# EUROPÄISCHE PATENTSCHRIFT

(11) **EP 1 393 418 B1**
(45) Veröffentlichungstag und Bekanntmachung des Hinweises auf die Patenterteilung: **22.06.2005**
(21) Anmeldenummer: 02761870.1
(22) Anmeldetag: 12.04.2002
(51) Int. Cl.: H01S 5/0687

(54) **VERFAHREN UND VORRICHTUNG ZUR REGELUNG DER MITTENWELLENLÄNGE EINES LASERS, INSBESONDERE EINES HALBLEITERLASERS**
METHOD AND DEVICE FOR REGULATING THE CENTRE WAVELENGTH OF A LASER, ESPECIALLY A SEMICONDUCTOR LASER
PROCEDE ET DISPOSITIF DE REGULATION DE LA LONGUEUR D'ONDE MOYENNE D'UN LASER, NOTAMMENT D'UN LASER A SEMI-CONDUCTEURS

(30) Priorität: 12.04.2001 DE 10118450; 01.10.2001 DE 10155331
(43) Veröffentlichungstag der Anmeldung: 03.03.2004
(73) Patentinhaber: FINISAR CORPORATION, Sunnyvale, CA 94089-1133 (US)
(72) Erfinder: HÜBNER, Bernd, 82049 Pullach (DE)
(74) Vertreter: Meissner, Bolte & Partner
(86) Internationale Anmeldenummer: PCT/DE2002/001380
(87) Internationale Veröffentlichungsnummer: WO 2002/084828

(56) Entgegenhaltungen:
- EP-A- 0 454 399
- WO-A-01/04999
- WO-A-98/05105
- KAZHARSKY O ET AL: "Broad continuous frequency tuning of a diode laser with an external cavity" OPTICS COMMUNICATIONS, NORTH-HOLLAND PUBLISHING CO. AMSTERDAM, NL, Bd. 137, Nr. 1-3, 15. April 1997 (1997-04-15), Seiten 77-82, XP004091521 ISSN: 0030-4018

## Beschreibung

Die Erfindung betrifft ein Verfahren und eine Vorrichtung zur Regelung der Mittenwellenlänge eines Lasers, insbesondere Halbleiterlasers, der einmodig betrieben wird und der ausgangsseitig ein wellenlängenselektives, teilweise reflektierendes optisches Element aufweist.

Das erfindungsgemäße Verfahren bzw. die erfindungsgemäße Vorrichtung ist insbesondere für Halbleiterlaser mit einem externen Resonator, der beispielsweise durch ein Fasergitter realisiert ist, einsetzbar, welches im Einkoppelende eines Pigtails integriert ist. Der Halbleiterlaser kann eine sog. Taper-Laser-Struktur aufweisen, bei der der Fleckradius bzw. der Öffnungswinkel des abgestrahlten Feldes an die entsprechenden Parameter der Pigtail-Faser angepasst sind.

Halbleiterlaser müssen in der Praxis, insbesondere bei einem Einsatz in Wellenlängen-multiplex-(WDM-)Systemen hinsichtlich ihrer Mittenwellenlänge geregelt werden. Die Mittenwellenlänge hängt insbesondere von der Temperatur und dem Alterungsgrad (Degradation) des Halbleiterlasers ab. Mit zunehmender Degradation verschiebt sich in der Regel die Mittenwellenlänge eines Halbleiterlasers in Richtung hin zu größeren Wellenlängen.

Bei WDM-Systemen ist es somit erforderlich, die Mittenwellenlänge eines Halbleiterlasers durch den Einsatz eines entsprechenden Regelkreises konstant zu halten. Als Steuergröße für eine Regelung der Mittenwellenlänge eignet sich dabei insbesondere die Temperatur des Laserchips, die beispielsweise über ein Peltier-Element eingestellt werden kann.

Bekannte Verfahren und Vorrichtungen zur Regelung der Mittenwellenlänge eines Lasers zweigen in der Regel von der optischen Ausgangsleistung des Lasers einen kleinen Teil der optischen Ausgangsleistung ab und führen diesen Teil über ein wellenlängenselektives optisches Filter. Die aus dem Filter austretende Leistung wird mittels einer Empfangsdiode detektiert, wobei sich die von dieser Monitordiode empfangene Lichtleistung und damit das elektrische Ausgangssignal der Monitordiode bei einer Änderung der Mittenwellenlänge des Lasers entsprechend ändert. Durch eine Auswertung des Monitorsignals und das Nachführen der Steuergröße, z.B. der elektrischen Ansteuergröße für das Peltier-Element kann dann die Mittenwellenlänge des Sendespektrums des Lasers im Rahmen einer geschlossenen Regelschleife konstant gehalten werden. Die Degradation des Lasers lässt sich somit innerhalb gewisser Grenzen ausregeln.

Nachteilig bei diesen bekannten Verfahren ist der zusätzliche Aufwand für die Monitordiode und das optische Filter.

Aus WO 01/04999 A1 ist eine Vorrichtung zur Stabilisierung der Wellenlänge der Ausgangsleistung einer Laserbaugruppe mit einer Vielzahl von gekoppelten optischen Elementen bekannt, die einen Laserresonator bilden, der einmodig ozilliert. Dabei ist eine Einrichtung zur Veränderung der effektiven optischen Länge des Resonators vorgesehen, mittels welcher die optische Länge wenigstens eines der optischen Elemente verändert wird. Die Vorrichtung umfasst des Weiteren einen Detektor, der die Ausgangsleistung der Laserbaugruppe abhängig von der Veränderung der optischen Länge des wenigstens einen optischen Elements überwacht. Eine Stabilisatoreinrichtung, welcher ein Signal des Detektors zugeführt ist, gibt ein vom Detektorsignal abhängiges Steuersignal an die Einrichtung zur Veränderung der effektiven optischen Länge des Resonators ab, wodurch die optische Länge des wenigstens einen optischen Elements so geregelt wird, dass der Laser stabil mit der Wellenlänge des betreffenden einzigen Modus schwingt.

Ausgehend von diesem Stand der Technik liegt der Erfindung die Aufgabe zugrunde, ein Verfahren zur Regelung der Mittenwellenlänge eines Lasers, insbesondere Halbleiterlasers, welcher ein wellenlängenselektives, zumindest teilweise reflektierendes optisches Element aufweist und welcher einmodig betrieben wird, zu schaffen, welches mit geringem Aufwand realisierbar ist und welches ein Konstanthalten der Mittenwellenlänge des Lasers innerhalb der erforderlichen Toleranzen gewährleistet. Des Weiteren liegt der Erfindung die Aufgabe zugrunde, eine Vorrichtung zur Durchführung eines derartigen Verfahrens zu schaffen.

Die Erfindung löst diese Aufgabe mit den Merkmalen der Patentansprüche 1 bzw. 14.

Die Erfindung geht von der Erkenntnis aus, dass bei einmodig betriebenen Lasern, insbesondere Halbleiterlaser mit externen Resonatoren, beispielsweise in Form von Fasergittern, die am rückwärtigen Spiegel austretende optische Leistung, die von einer Monitordiode erfassbar ist, stark von der optischen Länge des Resonators abhängt. Derartige Laser weisen die erforderliche kleine Bandbreite des Sendespektrums auf, um Einsatz in DWDM-(Dense-Wavelength-Division-Multiplex) Systemen finden zu können. Die optische Monitorleistung, die am rückwärtigen Ausgang des Lasers austritt und damit das Signal der Monitordiode des Lasers, weisen hierbei eine Periodizität von n·λ₀/2 auf, wobei n der effektive Brechungsindex des optischen Pfades innerhalb des Resonators und λ₀ die Mittenwellenlänge des Lasers bedeuten.

Das Maximum des Verlaufs der optischen Ausgangsleistung Pₘₒₙ am rückwärtigen Ausgang des Lasers abhängig von der optischen Länge Lₒₚₜ des Resonators hat dabei ein Maximum in dem Punkt, in dem auch eine optimale Unterdrückung der benachbarten (Seiten-) Moden gegeben ist.

Daher kann der Verlauf der optischen Ausgangsleistung am rückwärtigen Ausgang des Lasers bzw. eine entsprechende Erfassungsgröße dazu verwendet werden, um die Mittenwellenlänge des Lasers zu regeln und auf diese Weise insbesondere die nachteilige Auswirkung der Degradation des Lasers auszuregeln. Hierzu wird eine Steuergröße, die die optische Resonatorlänge Lₒₚₜ des Lasers beeinflusst, über einen vorbestimmten Bereich kontinuierlich oder schrittweise variiert. Die am rückwärtigen Ausgang des Lasers austretende optische Monitorleistung Pₘₒₙ oder eine hiervon abhängige Erfassungsgröße wird dabei kontinuierlich oder schrittweise erfasst. Aus dem Verlauf der optischen Monitorleistung Pₘₒₙ oder aus dem Verlauf der Erfassungsgröße kann dann die Steigung des Verlaufs in einem oder mehreren Punkten innerhalb des vorbestimmten Bereichs bestimmt werden. Die Steuergröße kann dann so eingestellt werden, dass sich ein vorbestimmter Wert der Steigung des Verlaufs der optischen Monitorleistung Pₘₒₙ oder des Verlaufs der Erfassungsgröße ergibt. Auf diese Weise kann ein bestimmter Sollwert für die optische Monitorleistung bzw. die Erfassungsgröße eingestellt werden, wobei dieser Sollwert einer bestimmten Mittenwellenlänge λ₀ des Lasers entspricht. An Stelle der Steigung kann auch eine funktionale Abhängigkeit verwendet werden, in welche die Steigung eingeht.

Beispielsweise kann so in einem Abstimmvorgang oder Eichvorgang für einen Laser ein relativ großer Bereich oder der insgesamt mögliche Bereich für die Steuergröße durchfahren und der entsprechende Verlauf der Erfassungsgröße aufgenommen werden. Die Soll-Mittenwellenlänge des Lasers λ₀, _{Soll} kann auf diese Weise sehr schnell und direkt eingestellt werden, ohne dass sich ein langes Einschwingverhalten einer entsprechenden Regelung störend auswirken würde. Hierzu muss lediglich die Steigung des Verlaufs der Erfassungsgröße in demjenigen Punkt des Verlaufs bekannt sein, bei dem das Ausgangsspektrum des Lasers die gewünschte Mittenwellenlänge λ_{0, Soll} aufweist.

Diese Steigung kann für jedes Exemplar eines derartigen Lasers einmalig ermittelt werden. Entsprechend geringe Fertigungstoleranzen vorausgesetzt, kann es sich auch als ausreichend erweisen, die betreffende Steigung der Erfassungsgröße für eine ganze Charge von gemeinsam hergestellten Lasern oder für einen bestimmten Typ einer Laserstruktur einmalig zu ermitteln.

Erfindungsgemäß wird zur Verbesserung des Chirp-Verhaltens die optische Resonatorlänge Lₒₚₜ auf einen Wert eingestellt, bei dem die zugehörige Mittenwellenlänge λ₀ ausreichend größer ist als die Bragg-Wellenlänge des wellenlängenselektiven, teilweise reflektierenden optischen Elements. Denn je näher der Arbeitspunkt hinsichtlich der Emissionswellenlänge demjenigen Wert für die optische Resonatorlänge Lₒₚₜ liegt, bei der der Modensprung für den ersten Nebenmodus auftritt, um so schlechter wird das Chirp-Verhalten des Lasers.

Nach der bevorzugten Ausfiihrungsform der Erfindung wird die von der optischen Monitorleistung Pₘₒₙ abhängige Erfassungsgröße durch das Ausgangssignal einer ohnehin vorhandenen Monitordiode gebildet, die üblicherweise für das Regeln des Arbeitspunkts des Lasers ohnehin erforderlich ist.

Das vorbeschriebene Verfahren zur Regelung der Mittenwellenlänge eines Lasers kann selbstverständlich nicht nur im Rahmen eines einmaligen Abstimm- oder Initialisierungsvorgangs, sondern auch in vorbestimmten zeitlichen Abständen durchgeführt werden.

Als Einrichtung, die die optische Resonatorlänge Lₒₚₜ des Lasers beeinflusst, eignet sich insbesondere eine Heiz- oder Kühleinrichtung für ein vom gesamten Laser umfasstes Laserelement. Die Heiz- oder Kühleinrichtung kann als reine Heizeinrichtung, beispielsweise in Form eines Heizwiderstands, realisiert sein.

Des Weiteren wäre es ebenfalls möglich, die axiale Position des wellenlängenselektiven, teilweise optischen Elements über eine geeignete Stelleinrichtung, beispielsweise ein Piezo-Element zu verändern.

In einer weiteren Ausführungsform kann die optische Resonatorlänge Lₒₚₜ des Lasers mittels einer Einrichtung einstellbar sein, welche die mechanischen Spannungsverhältnisse innerhalb wenigstens eines Teilbereichs des Lasers ändert, beispielsweise innerhalb des wellenlängenselektiven, zumindest teilweise reflektierenden optischen Elements.

Nach einer zu bevorzugenden Ausführungsform der Erfindung werden die optischen Eigenschaften des teilweise reflektierenden wellenlängenselektiven Elements konstant gehalten. Insbesondere kann hierzu die Temperatur des Elements konstant gehalten werden, welche dessen optischen Eigenschaften beeinflusst.

Um eine im Wesentlichen kontinuierliche Regelung der Mittenwellenlänge λ₀ der optischen Nutzausgangsleistung des Lasers zu gewährleisten, kann die die optische Resonatorlänge Lₒₚₜ des Lasers beeinflussende Steuergröße periodisch verändert werden. Beispielsweise kann die Temperatur des Lasers durch ein entsprechendes Ansteuern einer Heiz- oder Kühleinrichtung für ein vom Laser umfasstes Laserelement mit einer Periode von bis zu einigen Hundert Hertz variiert werden. Die Breite des Bereichs, der beim Variieren der Steuergröße durchfahren wird, muss dabei so gewählt sein, dass die hiermit verbundene Änderung der Mittenwellenlänge λ₀ der optischen Nutzausgangsleistung des Lasers innerhalb vorgegebener akzeptabler Schranken liegt.

Nach jedem Durchlaufen des Bereichs für die Steuergröße (in einer Richtung) kann die Steigung des Verlaufs der optischen Monitorleistung Pₘₒₙ bzw. die Steigung des Verlaufs der betreffenden Erfassungsgröße in einem Punkt des Bereichs für die Steuergröße, der relativ zu den Grenzen des Bereichs festgelegt ist, bestimmt werden. Beispielsweise kann jeweils für den Wert in der Mitte zwischen den Bereichsgrenzen des Bereichs für die Steuergröße die Steigung des Verlaufs der Erfassungsgröße ermittelt werden. Durch einen Vergleich des Werts für die Steigung der Erfassungsgröße in diesem Punkt mit dem Sollwert für die Steigung der Erfassungsgröße kann dann die Lage des Bereichs für die Steuergröße so verändert werden, dass der vorbestimmte Wert für die Steigung des Verlaufs der Erfassungsgröße erreicht wird. Der Betrag und die Richtung, um den der Bereich für die Steuergröße nach jedem Schritt verschoben wird, kann nach einem vorbestimmten Regelalgorithmus ermittelt werden.

Anstatt die Steigung in einem Punkt innerhalb der Grenzen des Bereichs für die Erfassungsgröße zu ermitteln, kann auch die mittlere Steigung des Verlaufs der Erfassungsgröße im gesamten Bereich oder innerhalb eines Teilbereichs ermittelt werden.

Des Weiteren kann selbstverständlich auch der Verlauf der Erfassungsgröße durch Bildung eines entsprechenden Mittelwerts bei einem mehrfachen Durchlaufen des Bereichs (in einer Richtung oder in beiden Richtungen) bestimmt werden, anstatt nach jedem Durchlaufen des Bereichs für die Steuergröße die betreffende Steigung zu ermitteln.

Nach der bevorzugten Ausführungsform der Erfindung wird die die optische Resonatorlänge Lₒₚₜ des Lasers beeinflussende Steuergröße so variiert, dass der hierdurch erzeugte Spektralanteil im gesamten Spektrum der optischen Monitorleistung außerhalb des Frequenzbereichs des optischen Nutzsignals liegt, das durch eine Ansteuerung des Lasers mit einem entsprechenden elektrischen Modulationssignal erzeugt wird. Die Steuergröße kann hierzu - eine lineare Abhängigkeit der optischen Resonatorlänge von der Steuergröße vorausgesetzt - sinusförmig variiert werden, um ein möglichst schmalbandiges Spektrum im Nutzsignal zu erzeugen. Bei nicht-linearer Abhängigkeit der optischen Resonatolänge von der Steuergröße kann die Kurvenform der periodischen Steuergröße so gewählt werden, dass sich eine sinusförmige zeitliche Änderung der optischen Resonatorlänge ergibt.

Da die optische Ausgangsleistung des Lasers im Bereich des Maximums des Verlaufs der Monitorleistung Pₘₒₙ nur eine relativ geringe Abhängigkeit von der optischen Resonatorlänge zeigt, wird jedoch selbst bei einer relativ großen Amplitude der Steuergröße die optische Ausgangsleistung Pₒₚₜ des Lasers nur geringfügig verändert. Praktisch wird jedoch die Amplitude der Steuergröße dadurch begrenzt, dass die Mittenwellenlänge innerhalb eines vorgegebenen Bereichs konstant gehalten werden muss.

Die bevorzugte Ausführungsform der erfindungsgemäßen Vorrichtung umfasst eine Auswerte- und Steuereinheit, die beispielsweise als Mikroprozessoreinheit ausgeführt sein kann, welcher das vorzugsweise bandpassgefilterte Signal der Erfassungsgröße zugeführt ist und welche in der vorstehend beschriebenen Weise das Ansteuersignal für eine Einrichtung zur Änderung der optischen Resonatorlänge Lₒₚₜ des Laser erzeugt. Sofern das Erfassungssignal neben einem Gleichanteil (der den Arbeitspunkt des Lasers definiert) unterhalb der Frequenz mit welcher das Steuersignal erzeugt wird, keine weiteren Fremdkomponenten enthält, kann anstelle eines Bandpassfilters auch ein Tiefpassfilter mit einer entsprechenden Grenzfrequenz verwendet werden.

Umfasst die Vorrichtung in üblicher Weise eine Regeleinheit für den Arbeitspunkt des Lasers, so muss das Erfassungssignal dieser Regeleinheit über ein Tiefpassfilter zugeführt sein, dessen Grenzfrequenz kleiner ist, als die Frequenz, mit welcher das periodische Steuersignal erzeugt wird.

Weitere Ausführungsformen der Erfindung ergeben sich aus den Unteransprüchen.

Die Erfindung wird nachfolgend anhand eines in der Zeichnung dargestellten Ausführungsbeispiels erläutert. In der Zeichnung zeigen:
- Fig. 1: ein schematisches Blockdiagramm einer Vorrichtung zur Regelung der Mittenwellenlänge eines Lasers nach der Erfindung;
- Fig. 2: ein Diagramm mit einem beispielhaften Verlauf der Abweichung Δλ = λ₀ - λ_{0,Soll} der tatsächlichen Mittenwellenlänge λ₀ von einem Sollwert λ_{0, Soll} in Abhängigkeit von der optischen Länge Lₒₚₜ des Resonators eines Lasers;
- Fig. 3: ein Diagramm mit einem Verlauf der optischen Monitorleistung Pₘₒₙ am rückwärtigen Ausgang des Lasers in Abhängigkeit von der optischen Länge Lₒₚₜ des Resonators des Lasers;
- Fig. 4: ein Diagramm mit einem Verlauf der optischen Nutzausgangsleistung Pₒₚₜ des Lasers in Abhängigkeit von der optischen Länge Lₒₚₜ des Resonators des Lasers;
- Fig. 5: ein Diagramm zur Verdeutlichung des Chirp-Verhaltens eines mit hohen Bitraten modulierten Fiber-Grating-Lasers;
- Fig. 6: ein Diagramm zur Veranschaulichung der Abhängigkeit der Steigung der optischen Monitorleistung bei Veränderung der optischen Resonatorlänge Lₒₚₜ von der Differenz der Sendewellenlänge und der Bragg-Wellenlänge des Gitters des Fiber-Grating-Lasers und
- Fig. 7: ein Diagramm zur Veranschaulichung der Abhängigkeit der auf den Absolutbetrag der optischen Monitorleistung Pₘₒₙ bezogenen Steigung der optischen Monitorleistung bei Veränderung der optischen Resonatorlänge Lₒₚₜ von der Differenz der Sendewellenlänge und der Bragg-Wellenlänge des Gitters des Fiber-Grating-Lasers.

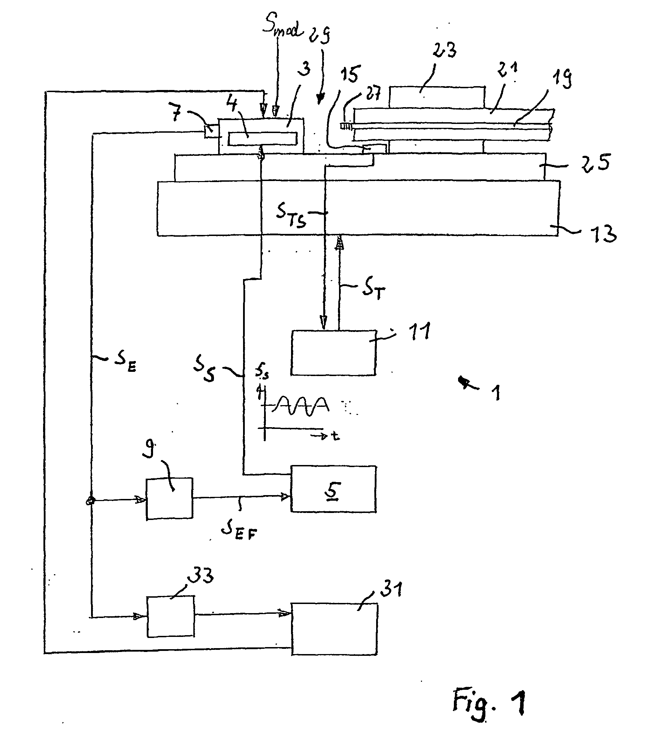

Die in Fig. 1 schematisch als Blockdiagramm dargestellte Vorrichtung 1 zur Regelung der Mittenwellenlänge eines Lasers 29, der aus einem Laserelement 3 und einem externen Resonator 27 besteht, umfasst eine Auswerte- und Steuereinheit 5, der das Erfassungssignal S_{E} einer Monitordiode 7 des Laserelements 3 zugeführt ist. Bei dem Laserelement 3 handelt es sich bei der dargestellten Ausführungsform um einen Halbleiterlaser, vorzugsweise um einen Laser mit Taper-Struktur. Die Monitordiode 7 ist vorzugsweise mit dem Laserelement 3 integriert ausgebildet.

Das Zuführen des Erfassungssignals S_{E} zur Auswerte- und Steuereinheit 5 erfolgt über ein (elektrisches) Filter 9, das als Bandpass- oder Tiefpassfilter ausgebildet sein kann. Der Auswerte- und Steuereinheit 5 wird somit das gefilterte Erfassungssignal S_{EF} zugeführt. Die Auswerte- und Steuereinheit 5 kann das gefilterte Erfassungssignal S_{EF} digital oder analog verarbeiten und ein digitales oder analoges Steuersignal S_{S} erzeugen. Das Steuersignal S_{S} ist bei der dargestellten Ausführungsform ein Steuersignal zur Regelung der Temperatur T des Laserelements 3.

Zur Regelung der Temperatur des Laserelements 3 ist unmittelbar auf dem Laserelement eine Heiz- oder Kühleinrichtung 4 vorgesehen, die beispielsweise als reine Heizeinrichtung in Form eines Heizwiderstands ausgebildet sein kann. Mit der Heiz- oder Kühleinrichtung 4 kann somit die Phase des Laserelements 3 bzw. optische Resonatorlänge des Laserelements und damit auch die optische Resonatorlänge des Lₒₚₜ des gesamten Lasers 29 beeinflusst werden. Da die Temperatur des externen Resonators in der nachfolgend erläuterten Art und Weise konstant gehalten werden kann, kann die Mittenwellenlänge des externen Resonators als Referenz dienen, die durch eine Stabilisierung der Temperatur des externen Resonators in relativ engen Grenzen (z.B. mit Abweichungen kleiner als 0,1 K) über die gesamte Lebensdauer des Lasers 29 konstant gehalten werden kann.

Die Heiz- oder Kühleinrichtung 4 kann auch einen Temperatursensor zur Erfassung der Temperatur des Laserelements 3 (nicht dargestellt) umfassen, welches der Auswerte- und Steuereinheit zugeführt sein kann. Auf diese Weise kann mittels der Auswerte- und Steuereinheit 5 auch eine Regelung der Temperatur in Form einer geschlossenen Regelschleife realisiert werden.

Zur Regelung der Temperatur T des gesamten Lasers 29 ist eine Temperaturregeleinheit 11 vorgesehen, welche ein Ansteuersignal S_{T} für eine Heiz- oder Kühleinrichtung 13 erzeugt. Zur Erfassung der Temperatur des gesamten Lasers 29 ist ein Temperatursensor 15 vorgesehen, dessen Ausgangssignal S_{TS} der Temperaturregeleinheit 11 zugeführt ist. Die Temperaturregeleinheit 11 vergleicht das ihr zugeführte Signal S_{TS} mit einem vorgegebenen, beispielsweise in der Temperaturregeleinheit 11 gespeicherten Sollwert für die Temperatur und erzeugt das Ansteuersignal S_{T} so, dass die Heiz- oder Kühleinrichtung 13 die Solltemperatur mit entsprechender Genauigkeit eingehalten wird. Der Temperatursensor 15 ist dabei vorzugsweise in unmittelbarer Nachbarschaft des externen Resonators 27 angeordnet, so dass dessen Temperatur auf dem gewünschen Sollwert konstant gehalten wird. Zusätzlich kann die Mittenwellenlänge des Lasers 29 innerhalb bestimmter Grenzen durch eine geeignete Wahl des Sollwerts für die Temperatur, die mittels der Heiz- oder Kühleinrichtung 13 erzeugt wird, also durch das Ändern der durch den externen Resonator 27 gebildeten Referenz beeinflusst, d.h. verschoben bzw. auf einen gewünschten Wert eingestellt werden.

Ist die Heiz- oder Kühleinrichtung 4 als reine Heizeinrichtung ausgebildet, so wird hierdurch die Temperatur des Laserelements 3 immer größer oder gleich der Temperatur der übrigen Komponenten des Lasers 29 sein.

Wie in Fig. 1 schematisch dargestellt, kann das Steuersignal S_{S} für die Heiz- oder Kühleinrichtung 4 sinusförmig mit einer vorbestimmten Frequenz um einen Mittelwert schwanken. Hierdurch ergibt sich eine im Wesentlichen ebenfalls sinusförmig schwankende Temperatur für das Laserelement 3.

Die optische Ausgangsleistung Pₒₚₜ des Laserelements 3 wird in das Ende eines Lichtwellenleiters 19 eingekoppelt, der als Pigtail ausgebildet sein kann. Das Ende des Lichtwellenleiters 19 kann, wie in Fig. 1 dargestellt, in einer beispielsweise aus Glas bestehenden Hülse 21 gehalten sein, die mittels eines Befestigungselements 23 auf einer gemeinsamen Trägerplatte 25 fixiert ist, auf welcher auch das Laserelement 3 montiert ist. Hierdurch ergibt sich ein temperaturstabiler und mechanisch stabiler Aufbau des Laserelements 3 und der im Befestigungselement 23 gehaltenen Hülse 21 mit dem Lichtwellenleiter 19. Selbstverständlich kann das Ende des Lichtwellenleiters 19 jedoch auch auf andere Weise gehalten und fixiert sein, beispielsweise in einer V-Nut eines entsprechenden Trägerelements.

Im vorderen Endbereich des Lichtwellenleiters 19 ist ein Fasergitter eingeschrieben, welches den externen Resonator 27 für das vorzugsweise als Taper-Laser ausgebildete Laserelement 3 bildet. Die Mittenwellenlänge des Lasers 29, der durch das Laserelement 3, das Fasergitter 27 und den zwischen den beiden Elementen liegenden optischen Pfad gebildet wird, ist, wie bereits vorstehend erläutert, durch das Ansteuersignal S_{T} für die Heiz- oder Kühleinrichtung 4 einstellbar.

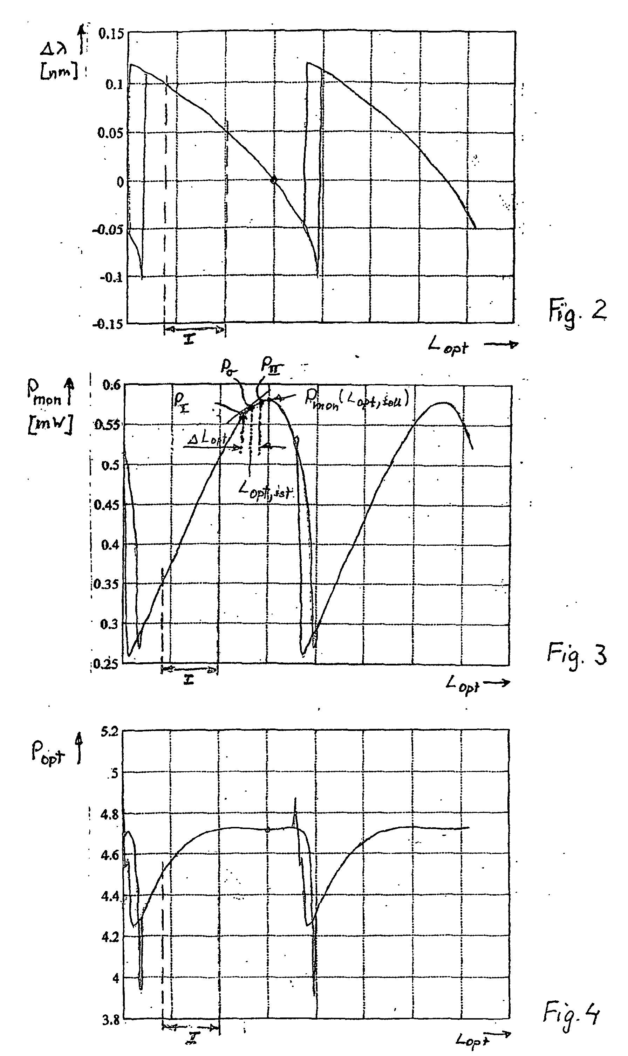

Nachfolgend wird die Funktionsweise der Vorrichtung 1 anhand der Diagramme in den Fig. 2 bis 4 näher erläutert.

Fig. 2 zeigt den Verlauf der Wellenlängeabweichung Δλ = λ₀ - λ_{0, Soll} der tatsächlichen Mittenwellenlänge λ₀ von einem Sollwert λ_{0, Soll} für die Mittenwellenlänge abhängig von der optischen Resonatorlänge Lₒₚₜ des Lasers 29. Die Wellenlängenabweichung Δλ ist auf der Ordinate in nm aufgetragen. An dieser Stelle sei erwähnt, dass bei den durch Simulation ermittelten Kurven in den Figuren 2 bis 4 die Temperatur des externen Resonators als konstant vorausgesetzt wurde.

Fig. 3 zeigt die optische Ausgangsleistung Pₘₒₙ am rückwärtigen Ende des Lasers 29 bzw. des Laserelements 3, welche von der Monitordiode 7 detektiert wird. Im einmodigen Betrieb des Lasers 29 ergibt sich das Maximum der Monitorleistung Pₘₒₙ in dem Punkt, der beispielsweise als Sollwert für die Mittenwellenlänge definiert werden kann.

Fig. 4 zeigt schließlich die optische Ausgangsleistung Pₒₚₜ des Lasers 29 abhängig von der optischen Resonatorlänge Lₒₚₜ des Lasers 29. Wie aus Fig. 4 ersichtlich, weist die optische Ausgangsleistung Pₒₚₜ im Bereich des Sollwerts λ_{0, Soll} für die Mittenwellenlänge nur eine relativ geringe Abhängigkeit von der optischen Resonatorlänge auf.

Selbstverständlich zeigen sämtliche Verläufe in den Fig. 2 bis 4 eine Periodizität mit der Periode n·λ₀/2, wobei mit n der effektive Brechungsindex im gesamten Pfad des Resonators des Lasers 29 bezeichnet ist.

Zur kontinuierlichen Regelung der Lage der Mittenwellenlänge λ₀ des Lasers 29 ist es daher möglich, das Steuersignal S_{T} periodisch, beispielsweise sinusförmig (wie in Fig. 1 dargestellt) zu variieren. Das gefilterte Erfassungssignal S_{EF} der Monitordiode 7, welches der Auswerte- und Steuereinheit 5 zugeführt wird, variiert demzufolge periodisch innerhalb eines Bereichs des in Fig. 3 für die optische Monitorleistung Pₘₒₙ dargestellten Verlaufs. Vorausgesetzt ist hierbei eine Proportionalität zwischen dem Ausgangssignal S_{E} der Monitordiode 7 und der optischen Monitorleistung Pₘₒₙ.

Die Grenzen des periodisch durchlaufenen Bereichs des in Fig. 3 dargestellten Verlaufs sind mit P_{I}=Pₘₒₙ(L_{opt,I}) bzw. P_{II}= Pₘₒₙ(L_{opt,I}) bezeichnet.

Die Auswerte- und Steuereinheit 5 erfasst den periodisch variierenden Verlauf des gefilterten Signals S_{EF} und ermittelt die Steigung des erfassten Verlaufs in einem Punkt P₀=Pₘₒₙ(L_{opt,Ist}) innerhalb des des vom Steuersignal S_{S} durchfahrenen Bereichs. Dieser Punkt kann beispielsweise als der Punkt in der Mitte des vom Steuersignal S_{S} durchfahrenen Bereichs gewählt werden.

Der Einfachheit halber sind in Fig. 3 der Bereich für das Steuersignal und das Erfassungssignal anhand der Kurve für die optische Monitorleistung Pₘₒₙ als Funktion der optischen Resonatorlänge Lₒₚₜ eingetragen. Auch wenn in der Praxis die optische Resonatorlänge Lₒₚₜ nicht linear von der Temperatur der Heiz- oder Kühleinrichtung 4 und damit vom Steuersignal S_{S} abhängt, soll dies zur Erläuterung des erfindungsgemäßen Verfahrens genügen. Der in Fig. 3 dargestellte Punkt der optischen Monitorleistung Pₘₒₙ(L_{opt, Ist}) entspricht daher dem betreffenden Punkt im Verlauf des gefilterten Erfassungssignals S_{EF} in Abhängigkeit vom Steuersignal.

Stellt die Auswerte- und Steuereinheit fest, dass die ermittelte Steigung nicht mit dem vorgegebenen Sollwert für die Steigung übereinstimmt, so kann die Auswerte- und Steuereinheit das Steuersignal Ss derart verändern, dass die Lage des vom Steuersignal periodisch durchfahrenen Bereichs so lange verändert wird, bis die tatsächlich festgestellte Steigung der vorbestimmten Steigung entspricht und damit die tatsächliche Mittenwellenlänge λ₀ der Soll-Mittenwellenlänge λ_{0, Soll}.

Anstatt die Steigung in einem einzigen Punkt innerhalb des vom Steuersignal S_{S} durchfahrenen Bereichs zu bestimmen, kann selbstverständlich auch eine mittlere Steigung im gesamten erfassten Verlauf des Erfassungssignals S_{EF} oder eines Teilbereichs hiervon ermittelt werden.

Das Ermitteln der Steigung kann nach jedem Durchfahren des Bereichs des Steuersignals S_{S} erfolgen oder auch nach einem Bilden eines mittleren Verlaufs bei einem mehrfachen Durchlaufen des Bereichs. Da die in den Fig. 2 bis 4 dargestellten Verläufe infolge von Nichtlinearitäten eine Hysterese aufweisen, kann auch jeweils ein Mittelwert des Verlaufs bei einem Durchfahren des Bereichs für das Steuersignal S_{S} in jeweils unterschiedlichen Richtungen gebildet werden.

Das vorstehend erläuterte kontinuierliche Regelverfahren kann auch durch das nachfolgend erläuterte Verfahren ergänzt und/oder ersetzt werden, das sich jedoch insbesondere als Abstimm- oder Initialisierungsverfahren für den Laser eignet.

Anstatt nur einen relativ kleinen Bereich für das Steuersignal S_{S} periodisch zu durchfahren, kann ein relativ großer Bereich für das Steuersignal S_{S} ein oder mehrmals durchfahren und das entsprechende Erfassungssignal S_{EF} erfasst werden. Dieser große Bereich für das Steuersignal S_{S} muss so groß sein, dass sichergestellt ist, dass zumindest im funktionsfähigen Zustand des Lasers 29 derjenige Punkt erreicht wird, in dem der Laser 29 die Soll-Mittenwellenlänge λ_{0, Soll} erreicht. Nach dem Aufnehmen des entsprechenden Verlaufs für das Erfassungssignal S_{EF} kann in diesem Fall derjenige Wert innerhalb des durchfahrenen Bereichs für das Steuersignal Ss ermittelt werden, in dem der erfasste Verlauf für das Erfassungssignal S_{EF} die gewünschte Steigung aufweist. Der betreffende Wert für das Steuersignal Ss kann dann ohne jegliche weitere Verzögerung, d.h. ohne Einschwingzeit des vorgeschriebenen kontinuierlichen Regelverfahrens eingestellt werden.

Zur Durchführung der beiden vorbeschriebenen Verfahren muss der Ansteuer- und Steuereinheit 5 lediglich der Wert der Steigung des Verlaufs für das Erfassungssignal S_{EF} bekannt sein, bei der der Laser 29 die gewünschte Soll-Mittenwellenlänge λ_{0, Soll} erreicht. Dieser Wert kann einmalig für ein bestimmtes Exemplar des Lasers 29 bzw. der Vorrichtung 1 ermittelt werden oder - entsprechend geringe Fertigungstoleranzen vorausgesetzt - für eine bestimmte Charge gemeinsam gefertigter Laser bzw. Vorrichtungen oder für einen bestimmten Typ eines Lasers 29 bzw. einer Vorrichtung 1.

Die in Fig. 1 dargestellte Vorrichtung 1 umfasst des Weiteren eine Arbeitspunktregeleinheit 31 für das Laserelement 3. Der Arbeitspunktregeleinheit 31 wird das Erfassungssignal S_{E} der Monitordiode 7 über ein Tiefpassfilter 33 zugeführt, dessen Grenzfrequenz so niedrig gewählt ist, dass der Arbeitspunktregeleinheit 31 lediglich der Gleichanteil des Signals S_{E} zugeführt wird. Die Arbeitspunktregeleinheit 31 steuert das Laserelement 3 in üblicher Weise an, wobei das Laserelement 3 mit einem entsprechenden Gleichstrom beaufschlagt wird. Zusätzlich zu diesem Steuersignal wird dem Laserelement 3 das Modulationssignal S_{mod} zugeführt.

Abschließend sei darauf hingewiesen, dass anstelle der Verwendung einer Heiz- oder Kühleinrichtung 4 für das Laserelement 4 die optische Länge Lₒₚₜ des Lasers 29 auch auf andere Weise verändert werden kann, z.B. durch den Einsatz einer Verschiebeeinrichtung für das stirnseitige Ende des Lichtwellenleiters 19 in Bezug auf den Abstand von der diesem zugewandten Stirnseite des Laserelements 3.

Des Weiteren könnte auf das Konstant-Halten der optischen Eigenschaften des externen Resonators verzichtet werden. In diesem Fall kann auf die Heiz- oder Kühleinrichtung 4 für das Laserelement 3 verzichtet werden. Statt dessen kann die Heiz- oder Kühleinrichtung 13 für den gesamten Laser so angesteuert werden, dass entsprechende Verschiebungen der Mittenwellenlänge des Lasers 29 auftreten. Allerdings ist dieses Verfahren in Folge der Schwankungen der optischen Eigenschaften der Referenz, d.h. des externen Resonators unter Umständen problematischer.

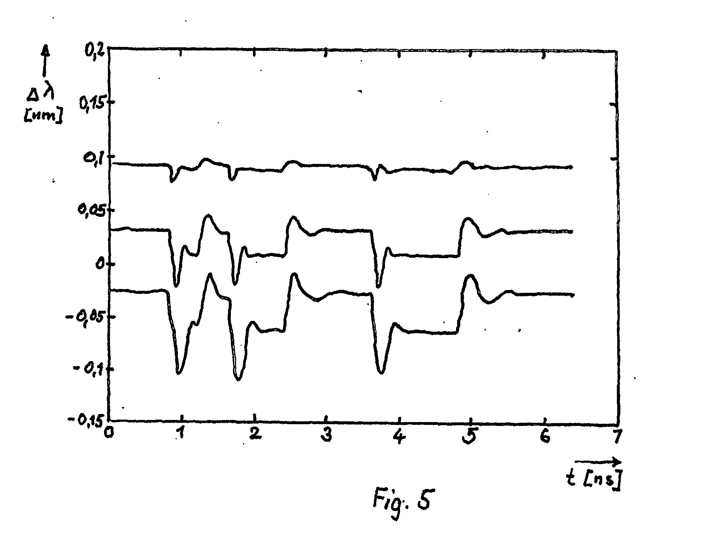

Während für CW-Laser oder nur mit niederen Bitraten modulierte Laser ohne Weiteres mit einem Arbeitspunkt hinsichtlich der emittierten Wellenlänge betrieben werden können, in dem die optische Monitorleistung Pₘₒₙ maximal ist, d.h. im Punkt Pₘₒₙ(L_{opt,soll}) in Fig. 3, und auch die optische Ausgangsleistung Pₒₚₜ des Lasers im maximalen Bereich liegt (vgl. Fig. 4), ist dies für mit hohen Bitraten modulierte Laser, insbesondere Fiber-Grating-Laser (FGL) nicht wünschenswert. Denn für derartige Laser muss das Chirp-Verhalten mit berücksichtigt werden. Je näher der Arbeitspunkt hinsichtlich der Emissionswellenlänge demjenigen Wert für die optische Resonatorlänge Lₒₚₜ liegt, bei der der Modensprung für den ersten Nebenmode auftritt (siehe die Unstetigkeit in der Mitte von Fig. 2), um so schlechter wird das Chirp-Verhalten des Lasers. Dieses Verhalten ist in Fig. 5 dargestellt. Die drei zeitlichen Verläufe der Mittenwellenlänge des Ausgangssignals zeigen umso größere Schwankungen der Mittenwellenlänge λ (dargestellt als Δλ=λ-λ_{bragg}), je kleiner Δλ unter Berücksichtigung des Vorzeichens ist. An dieser Stelle sei bemerkt, dass in der Darstellung gemäß Fig. 2 bis 4 die Bragg-Wellenlänge λ_{bragg}, die sich mit dem jeweils verwendeten Gitter des FGL ergibt, der Wellenlänge λ_{0,soll} entspricht.

Es ist in diesen Fällen somit von Vorteil, den Arbeitspunkt hinsichtlich der Wellenlänge durch die entsprechende Steuerung der optischen Resonatorlänge Lₒₚₜ in einem Bereich zu wählen, in dem Δλ=λ-λ_{bragg} ausreichend positiv ist, beispielsweise in dem in den Fig. 2 bis 4 mit I bezeichneten Bereich, der mit einem entsprechenden Bereich für Δλ (im dargestellten Beispiel ca. 0,05 nm≤ Δλ ≤0,1 nm) korrespondiert.

Wird zur Regelung des Arbeitspunktes, wie vorstehend erläutert lediglich die Steigung der optischen Monitorleistung Pₘₒₙ ausgewertet, ergibt sich in diesem Fall jedoch das Problem, dass sich die Steigung des von der optischen Resonatorlänge abhängigen Verlaufs von Pₘₒₙ in diesem Bereich nur in sehr geringem Maß ändert.

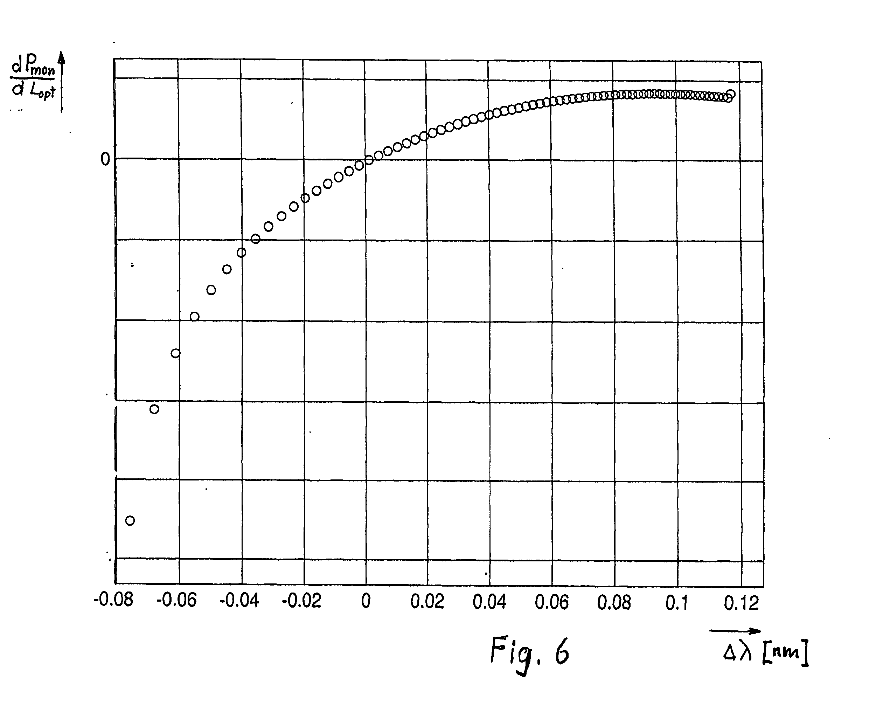

Fig. 6 zeigt die Abhängigkeit der Steigung dPₘₒₙ/dLₒₚₜ abhängig von Δλ=λ-λ_{bragg}. Hier ist deutlich erkennbar, dass im für den Betrieb des FGL interessanten Bereich I (z.B. 0,05 nm≤ Δλ ≤0,1 nm) kaum eine in der Praxis für eine Regelung des Arbeitspunktes verwertbare Änderung der Steigung vorliegt.

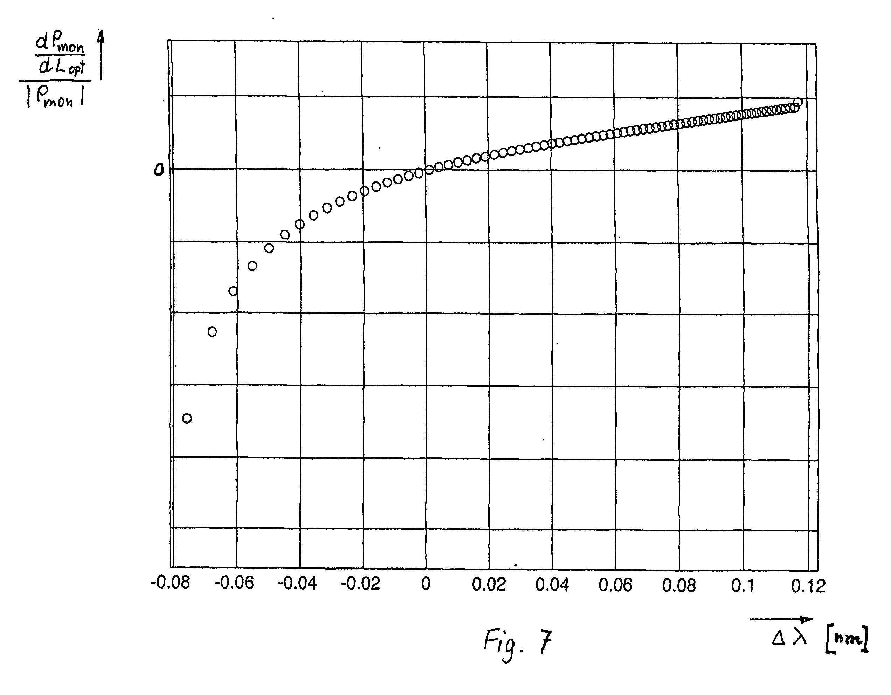

Als Lösung für diese Problematik wird anstelle der Steigung die auf den Absolutwert der Monitorleistung Pₘₒₙ bezogene Steigung zur Regelung verwendet. Wie aus der Darstellung in Fig. 7 ersichtlich, weist diese funktionale Abhängikeit im interessanten Bereich I einen fast linearen Verlauf mit einer verwertbaren Steigung und damit ausreichende Änderungen auf, um diese Größe praktisch zur Durchführung der Regelung des Arbeitspunktes verwerten zu können.

An dieser Stelle sei darauf hingewiesen, dass die Skalen der Ordinaten in den Fig. 5 und 6 beliebig gewählt sind und mit den gezeigten Verläufen lediglich das vorstehend erläuterte Prinzip verdeutlicht werden soll.

## Patentansprüche

1. Verfahren zur Regelung der Mittenwellenlänge eines Lasers, insbesondere Halbleiterlasers, welcher ein wellenlängenselektives, teilweise reflektierendes optisches Element (27) aufweist und welcher einmodig betrieben wird, unter Durchführung folgender Schritte:
a) kontinuierliches oder schrittweises Verändern einer die optische Resonatorlänge (Lₒₚₜ) des Lasers (29) beeinflussenden Steuergröße über einen vorbestimmten Bereich;
b) kontinuierliches oder schrittweises Erfassen des hiervon beeinflussten Verlaufs der an der dem optischen Ausgang des Lasers (29) abgewandten Seite austretenden optischen Monitorleistung (Pₘₒₙ) oder des Verlaufs einer von der optischen Monitorleistung abhängigen Erfassungsgröße
c) Einstellen der die optische Resonatorlänge (Lₒₚₜ) beeinflussenden Steuergröße derart, dass in einem Punkt innerhalb des Bereichs für die Steuergröße ein vorbestimmter Wert für die funktionale Abhängigkeit [dPₘₒₙ/dLₒₚₜ]/|Pₘₒₙ| erreicht wird, wobei dPₘₒₙ/dLₒₚₜ die Steigung des Verlaufs der optischen Monitorleistung (Pₘₒₙ) und |Pₘₒₙ| den Betrag der optischen Monitorleistung bedeuten, und
d) Einstellen der optischen Resonatorlänge Lₒₚₜ zur Verbesserung des Chirp-Verhaltens auf einen Wert wird, bei dem die zugehörige Mittenwellenlänge (λ) ausreichend größer ist als die Bragg-Wellenlänge des wellenlängenselektiven, teilweise reflektierenden optischen Elements (27).

2. Verfahren nach Anspruch 1, **dadurch gekennzeichnet, dass** die von der optischen Monitorleistung (Pₘₒₙ) abhängige Erfassungsgröße das Ausgangssignal (S_{S}; S_{EF}) einer Monitordiode (7) ist.

3. Verfahren einem der vorhergehenden Ansprüche, **dadurch gekennzeichnet, dass** die die optische Resonatorlänge (Lₒₚₜ) des Lasers (29) beeinflussende Steuergröße das Ansteuersignal (S_{S}) einer Heiz- oder Kühleinrichtung (4) zur Beeinflussung der Temperatur eines Teilbereichs des optischen Pfades des Resonators des Lasers (29) ist, vorzugsweise zur Beeinflussung der Temperatur eines Laserelements (3), welches vom Laser (29) umfasst ist.

4. Verfahren nach einem der Ansprüche 1 oder 2, **dadurch gekennzeichnet, dass** die die optische Resonatorlänge (Lₒₚₜ) des Lasers (29) beeinflussende Steuergröße das Ansteuersignal einer die axiale Position des wellenlängenselektiven, zumindest teilweise reflektierenden optischen Elements (27) verändernden Einrichtung ist.

5. Verfahren nach einem der Ansprüche 1 oder 2, **dadurch gekennzeichnet, dass** die die optische Resonatorlänge (Lₒₚₜ) des Lasers (29) beeinflussende Steuergröße das Ansteuersignal einer Einrichtung ist, welche die mechanischen Spannungsverhältnisse innerhalb wenigstens eines Teilbereichs des Lasers (29) ändert.

6. Verfahren nach einem der vorhergehenden Ansprüche, **dadurch gekennzeichnet, dass** die optischen Eigenschaften des wellenlängenselektiven, zumindest teilweise reflektierenden optischen Elements (27) auf vorbestimmten Werten konstant gehalten werden, vorzugsweise durch das Konstant-Halten der Temperatur des optischen Elements (27).

7. Verfahren nach einem der vorhergehenden Ansprüche, **dadurch gekennzeichnet, dass** die die optische Resonatorlänge (Lₒₚₜ) des Lasers (29) beeinflussende Steuergröße periodisch verändert wird, wobei die Breite des Bereichs so gewählt ist, dass die Änderung der Mittenwellenlänge (λ₀) der optischen Ausgangsleistung (Pₒₚₜ) des Lasers für jeden Wert der Steuergröße in dem vorbestimmten Bereich innerhalb vorgegebener Schranken liegt.

8. Verfahren nach Anspruch 7, **dadurch gekennzeichnet, dass**, vorzugsweise nach jedem Durchlaufen des Bereichs für die Steuergröße, die Steigung des Verlaufs der optischen Monitorleistung (Pₘₒₙ) oder des Verlaufs der Erfassungsgröße in einem Punkt des Bereichs für die Steuergröße ermittelt wird, der relativ zu den Grenzen des Bereichs festgelegt ist, vorzugsweise in der Mitte zwischen den Bereichsgrenzen.

9. Verfahren nach Anspruch 7, **dadurch gekennzeichnet, dass**, vorzugsweise nach jedem Durchlaufen des Bereichs für die Steuergröße, die mittlere Steigung des Verlaufs der optischen Monitorleistung (Pₘₒₙ) oder der Verlauf der Erfassungsgröße in einem Teilbereich oder im gesamten Bereichs für die Steuergröße ermittelt wird.

10. Verfahren nach einem der Ansprüche 7 bis 9, **dadurch gekennzeichnet, dass** die Lage des Bereichs für die Steuergröße so verändert wird, dass der vorbestimmte Wert für die Steigung erreicht wird.

11. Verfahren nach Anspruch 10, **dadurch gekennzeichnet, dass** der Betrag und die Richtung, um den der Bereich für die Steuergröße verschoben wird, nach einem vorbestimmten Regelalgorithmus ermittelt wird.

12. Verfahren nach einem der Ansprüche 7 bis 11, **dadurch gekennzeichnet, dass** die Veränderung der die optische Resonatorlänge Lₒₚₜ des Lasers (29) beeinflussende Steuergröße so erfolgt, dass der hierdurch erzeugte Spektralanteil im gesamten Spektrum der optischen Monitorleistung außerhalb des Frequenzbereichs des optischen Nutzsignals liegt, mit welchem der Laser angesteuert wird.

13. Verfahren nach einem der Ansprüche 7 bis 12, **dadurch gekennzeichnet, dass** die Breite des Bereichs für die Steuergröße so gewählt ist, dass bei einem Durchfahren des Bereichs die optische Nutzausgangsleistung (Pₒₚₜ) des Lasers im Wesentlichen unverändert bleibt oder die Änderung der optischen Nutzausgangsleistung innerhalb vorbestimmter Schranken liegt.

14. Vorrichtung zur Durchführung des Verfahrens nach einem der vorhergehenden Ansprüche,
a) mit einer ansteuerbaren Einrichtung (4) zur Änderung der optischen Resonatorlänge (Lₒₚₜ) des Lasers (29),
b) mit einer Einrichtung (7) zur Erfassung der an der dem optischen Ausgang des Laser abgewandten Seite austretenden optischen Monitorleistung (Pₘₒₙ) oder des Verlaufs einer von der optischen Monitorleistung abhängigen Erfassungsgröße und
c) mit einer Auswerte- und Steuereinheit (5), welcher ein der Erfassungsgröße entsprechendes Erfassungssignal der Einrichtung (7) zur Erfassung der optischen Monitorleistung (Pₘₒₙ) zugeführt ist und welche nach dem Verfahren nach einem der vorhergehenden Ansprüche ein der Steuergröße entsprechendes Steuersignal (S_{S}) für die Einrichtung (4) zur Änderung der optischen Resonatorlänge (Lₒₚₜ) erzeugt und dieser zuführt.

15. Vorrichtung nach Anspruch 14, **dadurch gekennzeichnet, dass** der Auswerte- und Steuereinheit (5) das Signal (S_{S}; S_{EF}) einer Monitordiode (7) zugeführt ist.

16. Vorrichtung nach Anspruch 14 oder 15, **dadurch gekennzeichnet, dass** die Einrichtung (4) zur Änderung der optischen Resonatorlänge (Lₒₚₜ) eine steuerbare Heiz- oder Kühleinrichtung, vorzugsweise ein Heizwiderstand, umfasst.

17. Vorrichtung nach einem der Ansprüche 14 bis 16, **dadurch gekennzeichnet, dass** die Auswerte- und Steuereinrichtung (5) das Verfahren nach einem der Ansprüche 6 bis 12 ausführt und dass das Erfassungssignal (S_{E}) über ein Tiefpass- oder Bandpassfilter (9) der Auswerte- und Steuereinrichtung (5) zugeführt ist, wobei das Tiefpass- oder Bandpassfilter (9) so dimensioniert ist, dass er das Frequenzband des periodischen Steuersignals (S_{S}) für die Einrichtung (4) zur Änderung der optischen Resonatorlänge des Lasers (29) passieren lässt.

18. Vorrichtung nach einem der Ansprüche 14 bis 17, **dadurch gekennzeichnet, dass** eine Heiz- oder Kühleinrichtung (13) für das Konstant-Halten der Temperatur insbesondere des teilweise reflektierenden optischen Elements (27) vorgesehen ist.

19. Vorrichtung nach einem der Ansprüche 14 bis 18, **dadurch gekennzeichnet, dass** eine Einrichtung (31) zur Regelung des Arbeitspunkts des Lasers (29) vorgesehen ist und dass das Erfassungssignal (S_{E}) dieser Einrichtung über ein Tiefpassfilter (33) zugeführt ist, wobei der Tiefpassfilter (33) so dimensioniert ist, dass der Einrichtung (31) zur Regelung des Arbeitspunkts im wesentlichen nur der Gleichanteil des Erfassungssignals (S_{E}) zugeführt wird.

## Claims

1. Method for controlling the centre wavelength of a laser, in particular a semiconductor laser, which comprises a wavelength-selective, partially reflective optical element (27) and is operated in a single-mode manner, by carrying out the following steps:
a) continuous or stepwise alteration, within a prespecified range, of a control quantity which influences the optical resonator length (Lₒₚₜ) of the laser (29);
b) continuous or stepwise detection of the progression thereby influenced of the optical monitor power (Pₘₒₙ) emitted on the side of the laser (29) opposite its optical output, or of the progression of a detection quantity dependent on the optical monitor power;
c) adjustment of the control quantity which influences the optical resonator length (Lₒₚₜ) so that at a point within the range for the control quantity a prespecified value for the functional relation [dPₘₒₙ/dLₒₚₜ]/|Pₘₒₙ| is reached, where dPₘₒₙ/dLₒₚₜ is the slope of the progression of the optical monitor power (Pₘₒₙ) and |Pₘₒₙ| signifies the amount of optical monitor power, and
d) adjustment of the optical resonator length L_{opt,} for improving the chirp behaviour, to a value at which the associated centre wavelength (λ) is sufficiently larger than the Bragg wavelength of the wavelength-selective, partially reflective optical element (27).

2. Method according to Claim 1, **characterized in that** the detection quantity depending on the optical monitor power (Pₘₒₙ) is the output signal (S_{S}; S_{EF}) of a monitor diode (7).

3. Method according to one of the preceding claims, **characterized in that** the control quantity that influences the optical resonator length (Lₒₚₜ) of the laser (29) is the triggering signal (S_{S}) for a heating or cooling device that influences the temperature of a subregion of the optical path of the resonator of the laser (29), preferably by influencing the temperature of a laser element (3) incorporated in the laser (29).

4. Method according to one of the claims 1 or 2, **characterized in that** the control quantity that influences the optical resonator length (Lₒₚₜ) of the laser (29) is the triggering signal for a device that changes the axial position of the wavelength-selective, at least partially reflective optical element (27).

5. Method according to one of the claims 1 or 2, **characterized in that** the control quantity that influences the optical resonator length (Lₒₚₜ) of the laser (29) is the triggering signal for a device that changes the mechanical tension conditions within at least a subregion of the laser (29).

6. Method according to one of the preceding claims, **characterized in that** the optical properties of the wavelength-selective, at least partially reflective optical element (27) are kept constant at predetermined values, preferably by keeping constant the temperature of the optical element (27).

7. Method according to one of the preceding claims, **characterized in that** the control quantity that influences the optical resonator length (Lₒₚₜ) of the laser (29) is altered periodically, the width of the range being selected so that the change in the centre wavelength (λ₀) of the optical output power (Pₒₚₜ) of the laser for each value of the control quantity lies in the predetermined range within specified boundaries.

8. Method according to Claim 7, **characterized in that**, preferably after each pass through the range for the control quantity, the slope of the progression of the optical monitor power (Pₘₒₙ) or the progression of the detection quantity is determined at a point within the range for the control quantity that is fixed relative to the limits of the range, preferably in the middle between the range limits.

9. Method according to Claim 7, **characterized in that**, preferably after each pass through the range for the control quantity, the average slope of the progression of the optical monitor power (Pₘₒₙ) or the progression of the detection quantity is determined in part of the range or in the entire range for the control quantity.

10. Method according to one of the claims 7 to 9, **characterized in that** the position of the range for the control quantity is changed so that the prespecified value for the slope is reached.

11. Method according to Claim 10, **characterized in that** the amount by which the range for the control quantity is shifted and the direction of the shift are determined according to a prespecified regulatory algorithm.

12. Method according to one of the claims 7 to 11, **characterized in that** the alteration of the control quantity that influences the optical resonator length Lₒₚₜ of the laser (29) is such that the spectral component thereby generated lies in the entire spectrum of the optical monitor power outside the frequency range of the optical data signal with which the laser is driven.

13. Method according to one of the claims 7 to 12, **characterized in that** the width of the range for the control quantity is selected such that during passage through that range the utilized optical output power (Pₒₚₜ) of the laser remains substantially unchanged or the change in the optical output power is within predetermined limits.

14. Apparatus for implementing the method according to one of the preceding claims,
a) with a triggerable device (4) for altering the optical resonator length (Lₒₚₜ) of the laser (29),
b) with a device (7) for detecting the optical monitor power (Pₘₒₙ) emitted from the side of the laser facing away from its optical output, or the progression of a detection quantity that depends on the optical monitor power, and
c) with an evaluation and control unit (5) to which is conducted a detection signal that corresponds to the detection quantity from the device (7)for detecting the optical monitor power (Pₘₒₙ), and which according to the method according to one of the preceding claims generates a control signal (S_{S}) corresponding to the control quantity for the device (4) for altering the optical resonator length (Lₒₚₜ) and sends it to this device (4).

15. Apparatus according to Claim 14, **characterized in that** the evaluation and control unit (5) receives the signal (S_{S},S_{EF}) from a monitor diode (7).

16. Apparatus according to Claim 14 or 15, **characterized in that** the device (4) for altering the optical resonator length (Lₒₚₜ) comprises a controllable heating or cooling device, preferably a heating resistor.

17. Apparatus according to one of the claims 14 to 16, **characterized in that** the evaluation and control device (5) implements the method according to one of the claims 6 to 12 and that the detection signal (S_{E}) is sent to the evaluation and control device (5) by way of a low-pass or band-pass filter (9), which is dimensioned such that it allows passage of the frequency band of the periodic control signal (S_{S}) for the device (4) that alters the optical resonator length (Lₒₚₜ) of the laser (29).

18. Apparatus according to one of the claims 14 to 17, **characterized in that** the heating or cooling device (13) is provided in order to keep constant the temperature, in particular of the partially reflective optical element (27).

19. Apparatus according to one of the claims 14 to 18, **characterized in that** a device (31) is provided to control the operating point of the laser (29) and that the detection signal (S_{E}) is sent to this device by way of a low-pass filter (33), which is dimensioned such that the device (31) for controlling the operating point receives substantially only the DC component of the detection signal (S_{E}).

## Revendications

1. Procédé de régulation de la longueur d'onde moyenne d'un laser, en particulier d'un laser à semi-conducteur, qui présente un élément optique (27) sélectif de longueur d'onde, partiellement réfléchissant et qui est amené à fonctionner en mode unique, en exécutant les étapes suivantes :
a) modification continue ou pas à pas d'une grandeur de commande agissant sur la longueur de résonateur optique (Lopt) du laser (29) sur une plage prédéterminée;
b) détection continue ou pas à pas de la courbe subissant cet effet de la puissance de moniteur optique (Pmon) sortant au côté éloigné de la sortie optique du laser (29) ou de la courbe d'une grandeur de détection dépendant de la puissance de moniteur optique;
c) réglage de la grandeur de commande agissant sur la longueur de résonateur optique (Lopt) de façon qu'à un point à l'intérieur de la plage pour la grandeur de commande, une valeur prédéterminée pour la dépendance fonctionnelle [dPmon/dLopt]/|Pmon| est atteinte, où dPmon/dLopt représente la montée de la courbe de la puissance de moniteur optique (Pmon) et |Pmon| la somme de la puissance de moniteur optique, et
d) réglage de la longueur de résonateur optique Lopt pour l'amélioration de l'effet de stridulation à une valeur, à laquelle la longueur d'onde moyenne associée (λ) est suffisamment plus grande que la longueur d'onde de Bragg de l'élément optique (27) sélectif de longueur d'onde, réfléchissant partiellement.

2. Procédé selon la revendication 1, **caractérisé en ce que** la grandeur de détection dépendant de la puissance de moniteur optique (Pmon) constitue le signal de départ (S_{S};S_{EF}) d'une diode de moniteur (7).

3. Procédé selon l'une des revendications précédentes, **caractérisé en ce que** la grandeur de commande agissant sur la longueur de résonateur optique (Lₒₚₜ) du laser (29) constitue le signal de commande (S_{S}) d'une installation de chauffage ou de refroidissement (4) pour agir sur la température d'une zone partielle du chemin optique du résonateur du laser (29), de préférence pour agir sur la température d'un élément de laser (3) qui est entouré par le laser (29).

4. Procédé selon l'une des revendications 1 ou 2, **caractérisé en ce que** la grandeur de commande agissant sur la longueur de résonateur optique (Lₒₚₜ) du laser (29) constitue le signal de commande d'une installation modifiant la position axiale de l'élément optique (27) sélectif de longueur d'onde, au moins partiellement réfléchissant.

5. Procédé selon l'une des revendications 1 ou 2, **caractérisé en ce que** la grandeur de commande agissant sur la longueur de résonateur optique (Lₒₚₜ) du laser (29) constitue le signal de commande d'une installation qui modifie les rapports de tension mécaniques à l'intérieur d'au moins une zone partielle du laser (29).

6. Procédé selon l'une des revendications précédentes, **caractérisé en ce que** les caractéristiques optiques de l'élément optique (27) sélectif de longueur d'onde, au moins partiellement réfléchissant, sont maintenues constantes aux valeurs prédéterminées, de préférence par le maintien constant de la température de l'élément optique (27).

7. Procédé selon l'une des revendications précédentes, **caractérisé en ce que** la grandeur de commande agissant sur la longueur de résonateur optique (Lₒₚₜ) du laser (29) est modifiée périodiquement, où la largeur de la plage est sélectionnée de façon que la modification de la longueur d'onde moyenne (λ₀) de la puissance de sortie optique (Pₒₚₜ) du laser pour chaque valeur de la grandeur de commande se situe dans la plage prédéterminée à l'intérieur de limites prédéfinies.

8. Procédé selon la revendication 7, **caractérisé en ce que**, de préférence après chaque passage de la plage pour la grandeur de commande, la montée de la courbe de puissance de moniteur optique (Pₘₒₙ) ou la courbe de la grandeur de détection est déterminée dans un point de la plage pour la grandeur de commande, qui est fixé relativement aux limites de la plage, de préférence au milieu entre les limites de la plage.

9. Procédé selon la revendication 7, **caractérisé en ce que**, de préférence après chaque passage de la plage pour la grandeur de commande, la montée moyenne de la courbe de la puissance de moniteur optique (Pₘₒₙ) ou bien la courbe de la grandeur de détection est déterminée dans une zone partielle ou dans la zone totale pour la grandeur de commande.

10. Procédé selon l'une des revendications 7 à 9, **caractérisé en ce que** la position de la plage pour la grandeur de commande est modifiée de façon que la valeur prédéterminée pour la montée soit atteinte.

11. Procédé selon la revendication 10, **caractérisé en ce que** la quantité et la direction, selon laquelle la plage pour la grandeur de commande est déplacée, est déterminée selon un algorithme de régulation prédéterminé.

12. Procédé selon l'une des revendications 7 à 11, **caractérisé en ce que** la modification de la grandeur de commande agissant sur la longueur de résonateur optique Lₒₚₜ du laser (29) a lieu de façon que la part spectrale ainsi produite se situe dans le spectre entier de la puissance de moniteur optique à l'extérieur de la plage de fréquences du signal utile optique au moyen duquel le laser est commandé.

13. Procédé selon l'une des revendications 7 à 12, **caractérisé en ce que** la largeur de la plage pour la grandeur de commande est sélectionnée de façon que lors d'un passage à travers la plage, la puissance de sortie utile optique (Pₒₚₜ) du laser reste sensiblement inchangée ou bien que la modification de la puissance de sortie utile optique se situe à l'intérieur de limites prédéterminées.

14. Dispositif pour la mise en oeuvre du procédé selon l'une des revendications précédentes ,
a) avec une installation (4) pouvant être commandée pour modifier la longueur de résonateur optique (Lₒₚₜ) du laser (29),
b) avec une installation (7) pour détecter la puissance de moniteur optique (Pₘₒₙ) sortant au côté éloigné de la sortie optique du laser ou la courbe d'une grandeur de détection dépendant de la puissance du moniteur optique et
c) avec une unité d'évaluation et de commande (5), à laquelle est transmis un signal de détection de l'installation (7) correspondant à la grandeur de détection pour détecter la puissance de moniteur optique (Pₘₒₙ) et qui, conformément au procédé selon l'une des revendications précédentes, produit un signal de commande (S_{S}) pour l'installation (4) correspondant à la grandeur de commande pour modifier la longueur de résonateur optique (Lₒₚₜ) et le transmet à celle-ci.

15. Dispositif selon la revendication 14, **caractérisé en ce que** le signal (S_{S};S_{EF}) d'une diode de moniteur (7) est transmis à une unité d'évaluation et de commande (5).

16. Dispositif selon la revendication 14 ou 15, **caractérisé en ce que** l'installation (4) pour la modification de la longueur de résonateur optique (Lₒₚₜ) comprend une installation de chauffage ou de refroidissement pouvant être commandée, de préférence une résistance chauffante.

17. Dispositif selon l'une des revendications 14 à 16, **caractérisé en ce que** l'installation d'évaluation et de commande (5) exécute le procédé selon l'une des revendications 6 à 12, et **en ce que** le signal de détection (S_{E}) est transmis par un filtre passe-bas ou passe-bande (9) à l'installation d'évaluation et de commande (5), où le filtre passe-bas ou passe-bande (9) est dimensionné de façon à laisser passer la bande de fréquences du signal de commande périodique (S_{S}) pour l'installation (4) pour modifier la longueur de résonateur optique du laser (29).

18. Dispositif selon l'une des revendications 14 à 17, **caractérisé en ce qu'**il est prévu une installation de chauffage ou de refroidissement (13) pour le maintien constant de la température, en particulier de l'élément optique partiellement réfléchissant (27).

19. Dispositif selon l'une des revendications 14 à 18, **caractérisé en ce qu'**une installation (31) pour régler le point de travail du laser (29) est prévue, et **en ce que** le signal de détection (S_{E}) est transmis à cette installation par un filtre passe-bas (33), où le filtre passe-bas (33) est dimensionné de façon que soit amenée à l'installation (31) pour régler le point de travail, pour l'essentiel seulement la composante continue du signal de détection (S_{E}).
